Europäisches Patentamt

European Patent Office

Office européen des brevets

(19)

(11) Veröffentlichungsnummer: **0 254 966**
**A2**

(12) **EUROPÄISCHE PATENTANMELDUNG**

(21) Anmeldenummer: **87110246.3**

(22) Anmeldetag: **15.07.87**

(51) Int. Cl.⁴: **H01H 13/70**

(30) Priorität: **28.07.86 CH 3036/86**

(43) Veröffentlichungstag der Anmeldung:
**03.02.88 Patentblatt 88/05**

(84) Benannte Vertragsstaaten:
**AT BE CH DE ES FR GB IT LI NL SE**

(71) Anmelder: **Schenk & Co.**
**Gewerbestrasse 10**
**CH-6330 Cham(CH)**

(72) Erfinder: **Tsanos, Georges**
**Devin 50**
**CH-1012 Lausanne(CH)**

(74) Vertreter: **Blum, Rudolf Emil Ernst et al**
**c/o E. Blum & Co Patentanwälte Vorderberg**
**11**
**CH-8044 Zürich(CH)**

(54) Flache Tastatur.

(57) Die Tastatur weist zwischen mehreren (getrennt) gezeigten) Folien oder Platten (l,2,3,4) an-geordnete Dehnungsmessstreifen (5) auf. Bei Druck auf den Tastenbereich oberhalb eines Dehnungs-messstreifens ändert dieser seinen elektrischen Wi-derstand. Die Widerstandsänderung ist auswertbar um ein der Taste der Tastatur zugeordnetes Nutzsi-gnal zu schalten. Die Tastatur kann sehr flach ausge-staltet werden, kann schon bei geringem Fingerdruck ansprechen und ist einfach herstellbar.

Fig.1

EP 0 254 966 A2

## Flache Tastatur

Die Erfindung betrifft eine flache Tastatur. Verschiedene Arten von flachen, in der Regel praktisch weglos zu bedienende Tastaturen sind bekannt. So sind z.B. bei bekannten, sogenannten Membran- oder Folientastaturen zwei beabstandet angeordnete, jeweils mit leitenden Tastenbereichen versehene Folien vorgesehen. Die einander gegenüberliegenden Tastenbereiche bzw. Tastenkontakte sind durch einen Luft enthaltenden Zwischenraum voneinander isoliert. Bei Druck auf den Tastenbereich einer Folie wird diese und die darauf befindliche leitende Schicht verformt, bis der Kontakt mit der Leitschicht auf der unteren Folie hergestellt ist. Da der Tastenkontakt somit bei jeder Betätigung bewegt und verformt wird, kann es nach einer gewissen Gebrauchsdauer zu Ermüdungserscheinungen und Fehlkontakten kommen. Die im Zwischenraum enthaltene Luft kann zur Kontaktoxidation beitragen und kann sich bei hoher Umgebungstemperatur oder geringem Aussendruck (z.B. in grosser Höhe) soweit ausdehnen, dass die Funktion der Tastatur beeinträchtigt oder die Tastatur beschädigt wird.

Bekannt sind ferner Tastaturen mit Piezokristallelementen, z.B. aus der europäischen Offenlegungsschrift 0 107 318. Bei einer solchen Tastatur ist allerdings ein Folienaufbau problematisch, insbesondere besteht die Gefahr des Kristallbruchs, wenn die Tastatur als flexible Folientastatur ausgestaltet werden soll.

Aus der US-PS 4 190 785 ist eine weitere Piezokristalltastatur bekannt, welche eine durchgehende piezoelektrische Beschichtung aufweist. Auch diese Tastatur kann nicht als flexible Folientastatur ausgeführt werden, und es besteht ferner eine grosse Gefahr des Uebersprechens zwischen den einzelnen Tastenbereichen.

Aus der französischen Offenlegungsschrift 2 455 402 ist eine Tastatur mit Elementen aus unter Druck leitendem Gummi bekannt. Diese Tastatur ist mit vielen Zwischenschichten versehen. Da ferner die Gummischicht für genügende Leitfähigkeit relativ dick sein sollte, ist es auf diese Weise nur - schwierig, eine sehr flache Tastatur zu schaffen.

Der Erfindung liegt deshalb die Aufgabe zugrunde, eine flache Tastatur zu schaffen, welche die genannten Nachteile nicht aufweist und insbesondere als flexible Folientastatur ausgestaltet werden kann, und welche einfach herstellbar ist.

Dies wird erreicht durch minestens eine als Auflage dienende Folie oder Platte, mindestens eine als Deckfolie dienende Folie oder Platte und mindestens einen auf einer der Folien oder zwischen den Folien angeordneten Dehnungsmessstreifen.

Im folgenden werden Ausführungsbeispiele der Tastatur anhand der Figuren näher erläutert. Dabei zeigen:

Fig. I eine schematische Darstellung einer Tastatur mit zwei Tasten, wobei die einzelnen Folien separat dargestellt sind;

Fig. 2 eine Schnittansicht einer Tastatur ähnlich derjenigen von Fig. I;

Fig. 3 eine schematische Ansicht einer elektronischen Schaltung zur Abfrage der Tastatur.

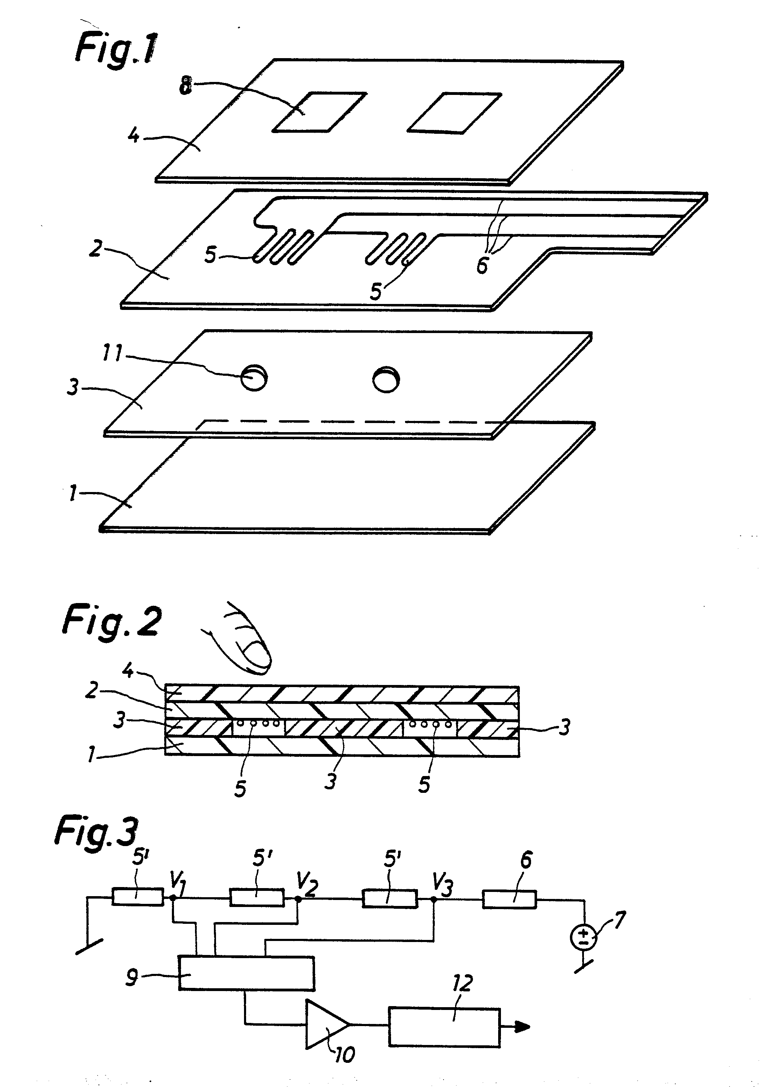

In Fig. I sind die Folien I,2,3 und 4 einer erfindungsgemässen Tastatur voneinander getrennt gezeigt, um eine bessere Darstellung zu ermöglichen. Die Folie oder Platte I bildet dabei eine Auflage für die weiteren Folien oder Platten. Die Folie 2 und die Folie 4 sind Deckfolien oder Platten, wobei die Folie 2 im dargestellten Beispiel die Dehnungsmessstreifen 5 und Leiterbahnen 6 trägt und die weitere Deckfolie Markierungen 8 aufweist, welche die Tastenbereiche für den Benützer kennzeichnen.

Die Folie I ist zur besseren Darstellung mit vergrösserter Dicke gezeigt. Diese Folie kann aus einem bekannten Kunststoffmaterial gefertigt sein, wie z.B. Polyester, Polyäthylen oder Polycarbonat. Bei einer Folientastatur beträgt ihre Dicke typischerweise ca. 0,I mm, kann aber in weitem Bereich frei gewählt werden. Anstelle der Folie kann auch eine Platte beliebiger Dicke aus Kunststoff oder auch aus anderen Materialien vorgesehen werden, z.B. Holz oder Metall.Bei einem Ausführungsbeispiel ist es möglich, die Tastatur nur mit zwei Folien zu realisieren (oder mit einer Folie und einer Platte oder mit zwei Platten). In diesem Falle wird die Deckfolie 2 direkt mit der Folie I verklebt, und die weiteren gezeigten Folien 3,4 werden nicht benötigt. Die Deckfolie 2 besteht vorzugsweise ebenfalls aus einem der genannten Kunststoffmaterialien und ihre Dicke liegt ebenfalls im genannten Bereich (vergrösserte Darstellung). Sind nur zwei Folien vorgesehen, so trägt die Folie 2 die Dehnungsmessstreifen 5 und Leiterbahnen 6 an ihrer der Folie I zugewandten Seite. Die Markierungen 8 können dann auf der anderen Seite der Folie 2 aufgebracht werden. Die Folie 2 kann ebenfalls durch eine Platte aus anderem Material ersetzt werden. Werden Platten I,2 verwendet, so ist deren Dicke maximal so zu wählen, dass die Dehnungsstreifen 5 bei Fingerdruck auf die Tastenbereiche noch eine erfassbare Widerstands änderung erfahren; bei der hohen Empfindlichkeit von Dehnungsmessstreifen (insbesondere Halbleitermessstreifen) ist die Dicke aber unkritisch.

Die Dehnungsmessstreifen werden mit der Folie 2 verklebt. Anschlussdrähte können ebenfalls mit der Folie verklebt und zum Folienrand geführt werden. Ferner können auf der Folie Leiterbahnen 6 aufgedruckt oder aufgeklebt werden, welche einerseits die Dehnungsmessstreifen kontaktieren und welche andererseits an den Rand der Tastatur geführt oder - wie in Fig. I gezeigt - auf einem Folienfortsatz weggeführt sind. Am Rand bzw. an dem Fortsatz kann ein (nicht gezeigter) Steckverbinder angeordnet werden, wie dies bereits bekannt ist. Die Dehnungsmessstreifen können handelsüblich auch auf separaten kleinen Folien angeordnet sein, welche lediglich zwischen den Folien positioniert werden und welche anschliessend durch die Verklebung der Folien I,2 an ihrem Platz gehalten werden. Für die Verklebung aller Folien kann ein entsprechender handelsüblicher Kunststoffkleber verwendet werden.

In Fig. I ist eine Ausführungsform mit weiteren Folien (oder Platten) 3 und 4 gezeigt. Die Folie 3 ist dabei zwischen den Folien I und 2 angeordnet und mit diesen verklebt. Die Folie 2 trägt wiederum die Dehnungsmessstreifen 5, vorzugsweise auf ihrer der Folie 3 zugewandten Seite und die Leiterbahnen 6. Unterhalb der Dehnungsmessstreifen 5 ist die Folie 3 mit Ausnehmungen II versehen. Das erlaubt bei Betätigung des Tastenbereiches eine stärkere Deformation der Folie 2 oberhalb der Ausnehmung und damit eine stärkere Widerstandsänderung des entsprechenden Dehnungsmessstreifens. Die Folie 3 stützt die Folie 2 an allen anderen Stellen ab und vermindert somit die Deformation nicht betätigter Dehnungsmessstreifen. Dies entspricht elektrisch einer Verminderung des Uebersprechens zwischen den Tasten.

Die weitere Deckfolie 4 (oder Deckplatte) ist mit den bereits genannten Markierungen 8 versehen.

Obschon die beispielhaft gezeigte Tastatur nur zwei Tasten (Dehnungsmessstreifen) aufweist, ist es selbstverständlich, dass erfindungsgemässe Tastaturen mit nur einer Taste oder mit einer grossen Anzahl von Tasten geschaffen werden können.

Fig. 2 zeigt eine Tastatur wie diejenige von Fig. I in Schnittdarstellung, wobei die Schnittstelle durch die beiden Tastenbereiche geht. Gleiche Bezugszeichen wie in Fig. I bezeichnen die gleichen Elemente. Die Dicke der Tastatur ist für die Darstellung wiederum vergrössert gezeigt. Für die Dicke der Folien 3 und 4 gilt ebenfalls das vorstehend Gesagte. Insbesondere die Folie oder Platte 4 kann wesentlich dicker als 0,I mm gewählt werden, um die Tastatur zu schützen.

Als Dehnungsmessstreifen können handelsübliche Streifen aus Draht oder Halbleitermaterial Verwendung finden. Jeder Streifen weist dabei einen Sollwiderstand auf, der sich bei Durchbiegung infolge des Fingerdrucks auf den Tastenbereich ändert. Bekannte Ausführungsformen von Dehnungsmessstreifen sowie deren elektrische Kennwerte sind z.B. beschrieben in "Elektronik ohne Ballast", O. Limann, München I970, Seiten 243-254.

Schaltungsmässig kann jeder Dehnungsmessstreifen als elektrischer Widerstand betrachtet werden. Es kann jeder dieser Widerstände auf bekannte Art in einer Brücke betrieben werden, um die Aenderung des Widerstands bzw. die Betätigung der Taste zu detektieren, doch wird diese Auswertung bei vielen Tasten zu aufwendig.

Fig. 3 zeigt eine Auswerteschaltung, welche insbesondere für Halbleiterdehnungsmessstreifen mit ihren relativ grossen Widerstandsänderungen geeignet ist. Dabei sind die als Widerstände 5' dargestellten Dehnungsmessstreifen in Serie geschaltet und bilden - allenfalls mit einem Vorwiderstand 6 - einen Spannungsteiler. Ein Multiplexer schaltet die Teilspannungen $V_1$, $V_2$, $V_3$ periodisch nacheinander über einen Verstärker I0 an eine Auswerteelektronik I2, welche z.B. eine Reihe von Komparatoren aufweist. Jede Teilspannung $V_n$ wird dabei mit der Sollspannung an diesem Knotenpunkt verglichen, welche bei unbetätigter Taste vorhanden ist. Weicht die Teilspannung ab, so bedeutet dies, dass sich der entsprechende Widerstandswert geändert hat, bzw. dass die Taste gedrückt ist. Die Auswertschaltung I2 schaltet dann ein entsprechendes Relais oder einen Halbleiterschalter, welcher das eigentliche Nutzsignal schaltet. Natürlich kann die Auswertung der Widerstandsänderung der einzelnen Taste auch auf irgendeine andere bekannte Weise erfolgen.

Bei einem weiteren Ausführungsbeispiel kann die Tastatur nur aus einer Folie bestehen. Die Tastenbereiche sind dann als leicht erhöhte Stellen der Folie ausgeführt (z.B. durch Prägung), an deren Unterseite jeweils ein Dehnungsmessstreifen aufgebracht ist. Die Unterseite der Folie kann mit einer Klebebeschichtung versehen sein, was die einfache Montage der Tastaturfolie erlaubt. Auf diese Weise wird eine besonders einfache und billige Tastatur geschaffen.

Das Aufbringen der Dehnungsmessstreifen auf die jeweilige Folie kann bei den erwähnten Beispielen auch durch Aufdrucken, Aufspritzen oder Aufdampfen des Messstreifenmaterials erfolgen.

Bei der Auswerteschaltung nach Fig. 3 können die Spannungen an $V_1$, $V_2$ und $V_3$ mittels Operationsverstärker vorverstärkt werden, bevor sie an den Multiplexer 9 gegeben werden. Vorzugsweise wird ferner ein weiterer, nicht zu betätigender Dehnungsmessstreifen vorgesehen, dessen umgebungsbedingte Widerstandsänderung (infolge Aenderung von Luftdruck, Temperatur, Feuchtigkeit) zur Kompensation der umgebungsbedingten Widerstandswertänderung der anderen Dehnungsmessstreifen benützt werden kann.

Die die Dehnungsmessstreifen tragende Folie oder Platte kann ferner zwischen den Dehnungsmessstreifen mit Schwächungszonen (Löcher, Einschnitte usw.) versehen werden, was die Kraftübertragung von einem betätigten Messstreifen auf die unbetätigten über die Trägerfolie vermindert und damit das elektrische Uebersprechen zwischen den Tasten. Der Hohlraum unter den Dehnungsmessstreifen (Fig. 2) kann luftleer oder luftgefüllt sein. Sofern gewünscht kann jeder dieser Räume über eine jeweilige kleine Oeffnung in der Folie I mit dem Umgebungsdruck ausgeglichen sein.

Innerhalb oder unterhalb der Folien kann ein mechanisches Element ("Frosch") zum Definieren eines Druckpunkts vorgesehen werden.

**Ansprüche**

I. Flache Tastatur, gekennzeichnet durch mindestens eine Folie oder Platte und mindestens einen damit verbundenen Dehnungsmessstreifen.

2. Flache Tastatur nach Anspruch I, gekennzeichnet durch mindestens eine als Auflage dienende Folie (I) oder Platte, mindestens eine als Deckfläche dienende Folie (2) oder Platte und mindestens einen auf einer der Folien oder zwischen den Folien angeordneten Dehnungsmessstreifen (5).

3. Tastatur nach Anspruch 2, dadurch gekennzeichnet, dass zwischen Auflage und Deckfläche eine weitere Folie als Abstandshalter vorgesehen ist, welche eine Ausnehmung im Bereich des Dehnungsmessstreifens aufweist.

4. Tastatur nach einem der Ansprüche I,2 oder 3, dadurch gekennzeichnet, dass die als Deckfläche dienende Folie oder Platte mit einem Aufdruck versehen ist, welcher den Tastenbereich markiert.

5. Tastatur nach einem der Ansprüche I bis 4, dadurch gekennzeichnet, dass als Dehnungsmessstreifen ein Drahtdehnungsmessstreifen vorgesehen ist.

6. Tastatur nach einem der Ansprüche I bis 4, dadurch gekennzeichnet, dass als Dehnungsmessstreifen ein Halbleiterdehnungsmessstreifen vorgesehen ist.

7. Tastatur nach einem der Ansprüche 5 oder 6, dadurch gekennzeichnet, dass der Dehnungsmessstreifen mittels auf einer oder mehreren der Folien oder Platten aufgebrachten Leiterbahnen kontaktiert wird.

8. Tastatur nach einem der Ansprüche I bis 7, dadurch gekennzeichnet, dass mehrere in Serie geschaltete Dehnungsmessstreifen mehrere Tastenbereiche bilden und eine Multiplexerschaltung vorgesehen ist, wobei eine Spannung an die Serieschaltung anlegbar und die Teilspannungen über den Dehnungsmessstreifen durch die Multiplexerschaltung periodisch abtastbar sind, um das Betätigen eines Tastenbereiches zu detektieren.

9. Tastatur nach einem der vorangehenden Ansprüche, dadurch gekennzeichnet, dass ein keinen Tastenbereich bildender Kompensationsdehnungsmessstreifen vorgesehen ist.

I0. Tastatur nach einem der vorangehenden Ansprüche, dadurch gekennzeichnet, dass mehrere Dehnungsmessstreifen vorgesehen sind und die die Dehnungsmessstreifen tragende Folie oder Platte mit Schwächungszonen versehen ist, welche die Kraftübertragung von einem betätigten auf die unbetätigten Dehnungsmessstreifen vermindern.

*Fig.1*

*Fig.2*

*Fig.3*